# EUROPEAN PATENT APPLICATION

(11) **EP 4 383 317 A1**
(43) Date of publication of application: **12.06.2024**
(21) Application number: 22211716.0
(22) Date of filing: 06.12.2022
(51) Int. Cl.: H01L 21/56, H01L 23/31, H01L 23/29, H01L 23/495, H01L 23/00, H01L 25/07, H01L 25/18

(54) **A METHOD FOR FABRICATING A SEMICONDUCTOR PACKAGE WITH IMPROVED THERMAL PERFORMANCE**

(71) Applicant: Infineon Technologies Austria AG, 9500 Villach (AT)
(72) Inventor: YONG, Khai Seen, 79100 Singapore (SG); WAGIMAN, Mohamad Yazid, 510101 Singapore (SG); REYNOSO, Dexter Inciong, 545085 Singapore (SG)
(74) Representative: Lambsdorff & Lange Patentanwälte Partnerschaft mbB

(57) **Abstract**

A method (100) for fabricating a semiconductor package comprises providing a mold comprising a mold cavity (110), providing a semiconductor device comprising a plurality of semiconductor modules, each one of the semiconductor modules comprising at least one semiconductor die disposed on a substrate (120), placing the semiconductor device in the mold cavity (130), providing a mold material in a softened state and at least partially filling of the mold cavity with the mold material through a gate (140), curing of the mold material (150), and sawing the cured intermediate product along saw lines separating the semiconductor modules from each other (160).

## Description

### BACKGROUND

The present disclosure relates to a method for fabricating a semiconductor package and to a semiconductor package.

A perennial issue with power semiconductor devices is the efficient dissipation of the heat generated by the power semiconductor - usually a power transistor. This applies in particular to so-called intelligent power modules (IPMs), since these have a logic chip in addition to the power semiconductor in the module, which logic chip and also other devices like diodes or passives can be affected by excessive heat.

Current state of the art is to use a thermal mold compound, i.e. a mold compound with a high thermal conductivity, or to use thermally conducting but electrically insulating materials like e.g. direct copper bond (DCB), thermal sheets, novel applications known under the term advanced isolation, to improve the thermal performance of the package, often by the additional use of ceramic materials.

For these and other reasons, there is a need for the present invention.

### SUMMARY

A first aspect of the present disclosure is related to a method for fabricating a semiconductor package, comprising providing a mold comprising a mold cavity, providing a semiconductor device comprising a plurality of semiconductor modules, each one of the semiconductor modules comprising at least one semiconductor die disposed on a substrate, placing the semiconductor device in the mold cavity, providing a mold material in a softened state and at least partially filling of the mold cavity with the mold material through a gate, curing of the mold material, and sawing the cured intermediate product along saw lines separating the semiconductor modules from each other.

A second aspect of the present disclosure is related to a semiconductor package comprising a semiconductor module comprising at least one semiconductor die disposed on a substrate, an encapsulant embedding the semiconductor module, the encapsulant comprising an upper horizontal surface, a lower horizontal surface, and side surfaces connecting the upper horizontal surface and the lower horizontal surface, wherein at least part of the side surfaces are sawn surfaces.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a flow diagram illustrating the method for fabricating the semiconductor package according to the first aspect.
Fig. 2 comprises Fig. 2A to 2C and shows a cross-sectional side view of the mold and the semiconductor device placed in the mold (A), a partial cross-sectional side view of the semiconductor device, namely of one of the semiconductor modules (C).
Fig. 3 comprises Fig. 3A and 3B and shows the mold and the semiconductor device placed in the mold in a perspective view from the top (A) and from the bottom (B).
Fig. 4 shows a cross-sectional side view on a cured intermediate product comprising two semiconductor modules with dashed lines indicating the sawing lines where the packages are to be sawn apart.
Fig. 5 comprises Fig. 5A and 5B and shows cross-sectional side views on semiconductor packages according to the second aspect.
Fig. 6 shows a top view on a mold apparatus for parallel fabrication of a plurality of semiconductor packages.

### DETAILED DESCRIPTION

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

### DESCRIPTION OF EMBODIMENTS

Molding techniques or injection-molding methods are widely used for processing plastics. With them, many different articles can be produced, for example from thermoplastic or thermosetting materials. The techniques of transfer molding and compression molding are used particularly often.

In the case of transfer molding, which is applied in the present disclosure, a defined quantity of the molding material, typically a thermosetting material, is filled into the otherwise closed mold cavity through a gate. During transfer molding, the walls of the mold are typically heated to a temperature above the melting temperature of the molding material in order to obtain good flow properties of the material within the cavity.

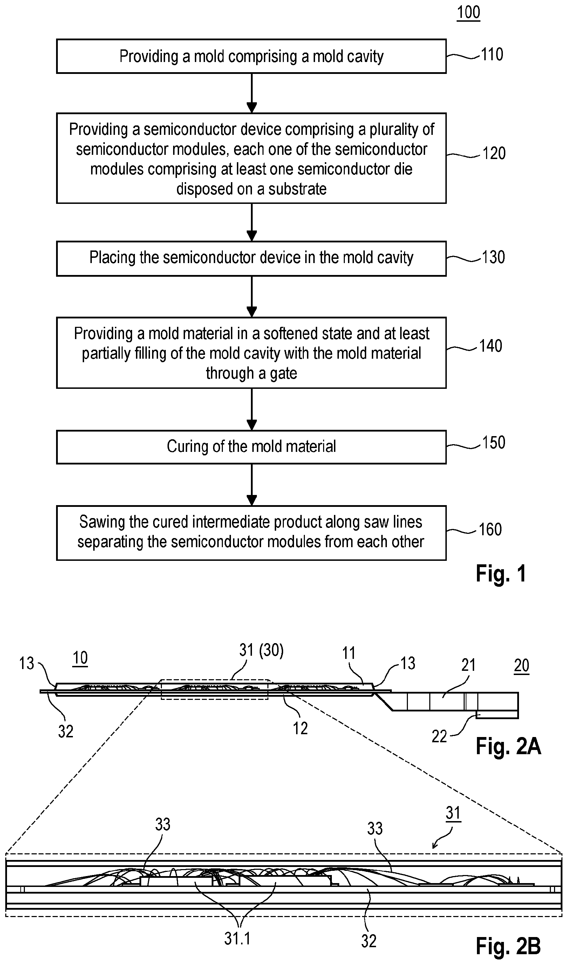

Fig. 1 shows a flow diagram illustrating the method for fabricating the semiconductor package according to the first aspect.

The method 100 for fabricating a semiconductor package comprises providing a mold comprising a mold cavity (110), providing a semiconductor device comprising a plurality of semiconductor modules, each one of the semiconductor modules comprising at least one semiconductor die disposed on a substrate (120), placing the semiconductor device in the mold cavity (130), providing a mold material in a softened state and at least partially filling of the mold cavity with the mold material through a gate (140), curing of the mold material (150), and sawing the cured intermediate product along saw lines separating the semiconductor modules from each other (160).

The various embodiments of the method are described with reference to the following figures.

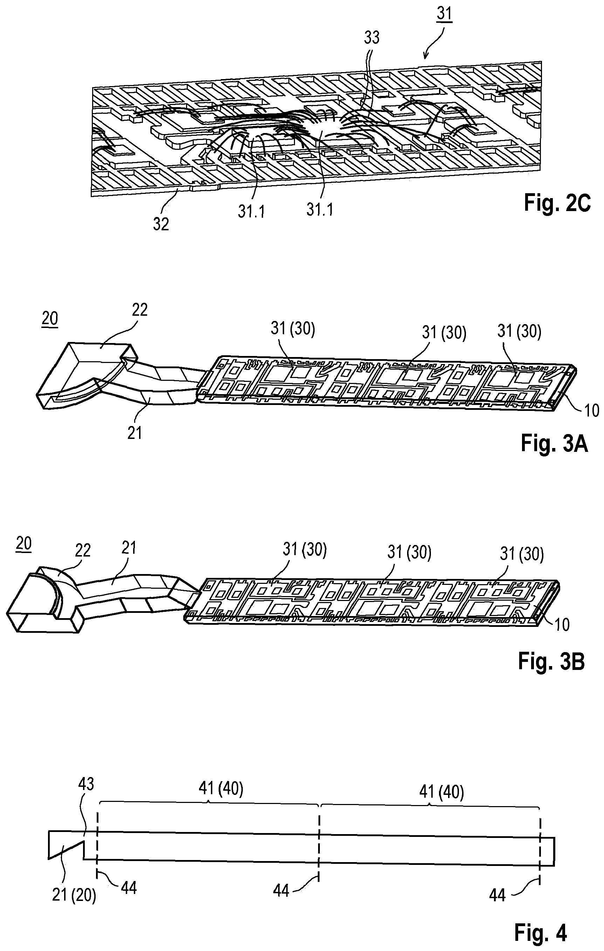

Fig. 2 comprises Fig. 2A to 2C and shows a cross-sectional side view of the mold and the semiconductor device placed in the mold (A), a partial cross-sectional side view of the semiconductor device, namely of one of the semiconductor modules (C).

Fig. 2A shows a mold 10 comprising an upper horizontal wall 11, a lower horizontal wall 12, and vertical side walls 13 interconnecting the upper horizontal wall 11 and the lower horizontal wall 12, wherein on the right hand side an opening for the passage of the mold material - usually called gate - is formed in the respective vertical side wall 13.

The gate of the mold 10 is connected with a feeding system 20 comprising a feed line 21 which itself is connected with a circular distributor 22 - usually called cull. The cull 22 is connected with a supply container (not shown). The cull 22 can be connected with at least one further mold as will be shown later. Moreover a plurality of culls can be provided which are all connected with the supply container.

Figs. 2A and 2B show a configuration in which a semiconductor device 30 is inserted in the mold 10. In this embodiment the semiconductor device 30 comprises 3 semiconductor modules 31 one of which is shown in more detail in Fig. 2B. The semiconductor module 31 comprises a plurality of semiconductor dies 31.1 which are mounted on a substrate 32 and which can be interconnected by bond wires 33, in particular gold wires and copper wires. The semiconductor modules 31 can be identical and each one of them can be comprised of an intelligent power module (IPM). Each one of the The semiconductor modules 31 can be arranged laterally side by side along a row which can at best be seen in Fig. 3. The substrate 32 can be a leadframe, in particular a copper leadframe.

As can at best be seen in Fig. 2B, the semiconductor device 30 is placed in such a way in the mold cavity that an upper surface of the substrate 32 is spaced by a first distance from the upper horizontal wall 11 of the mold 10, and a lower surface of the substrate 32 is spaced by a second distance from the lower horizontal wall of the mold 10. As an example thereof, the first distance is greater than the second distance. As another example thereof, both the first distance and the second distance are less than 1 mm. As a result thereof, the mold material when supplied through the gate will flow slightly faster in the upper region than in the lower region of the mold cavity.

As to the mold material, a large number of different materials, in particular thermoplastic and thermosetting materials, come into consideration in the present disclosure.

The mold material can in general be a material out of the group containing a duromer, an elastomer or a thermoplastic. The mold material can also be one or more of a liquid mold compound, a resin, an organic resin, an epoxy resin, an inorganic resin, a polyimide, a cyanate ester, a silicone, or mixtures of the above components.

The mold material can also be made of one of the above mentioned materials and furthermore being filled with special filler particles for increasing the thermal conductivity, e.g. for instance comprising or consisting of metal oxide or metal nitride filler particles, in particular AlO, SiO, ZrO₂, Si₃N₄, BN, AlN, or diamond.

In particular when thermosetting materials are used, which as a result of the contact with the hot mold crosslink to an increasing extent as they flow over an increasing distance, or highly viscous thermoplastic materials are used, in particular with a mold that is not heated, the formation of voids (pockets of air or gas resembling bubbles or cracks) can cause flaws in the fabricated packages. Voids form in particular in regions within the mold cavity that are of a particularly intricate and capillary nature, and in cases where particularly small packages are produced. Voids may represent blemishes, but may also lead to malfunctions of the fabricated article produced, for example in the case of semiconductor devices.

It has been shown that with the configuration of the mold 10 as of the present disclosure, in particular the dynamic of the flow of the mold material, the formation of voids can be significantly reduced

Fig. 3 comprises Fig. 3A and 3B and shows the mold and the semiconductor device placed in the mold in a perspective view from the top (A) and in a perspective view from the bottom (B).

As already shown in Fig. 2A, the end of the feed line is connected to the gate in such a way that the mold material is fed into the cavity of the mold directly below the lower surface of the lead frame. Thus, the mold material initially flows only into the lower cavity, but subsequently also into the upper cavity through the numerous openings of the leadframe. The mold can be heated to a temperature of 175°C, for example.

A feature of the molding device shown and described in Figs. 2 and 3 is that the cull 22 is connected directly to the mold cavity 10 by a single feed line 21, whereas in known systems additional feed lines, so-called runners, are provided.

Fig. 4 shows a cross-sectional side view on a cured intermediate product comprising two semiconductor modules with dashed lines indicating the sawing lines where the packages are to be sawn apart.

In this highly simplified embodiment, the semiconductor device 40 has only two semiconductor modules 41 and 42. The gate 43 is located on the left side. After curing the semiconductor device 40, the two semiconductor modules 41 and 42 are separated from each other by sawing along the saw lines 44.

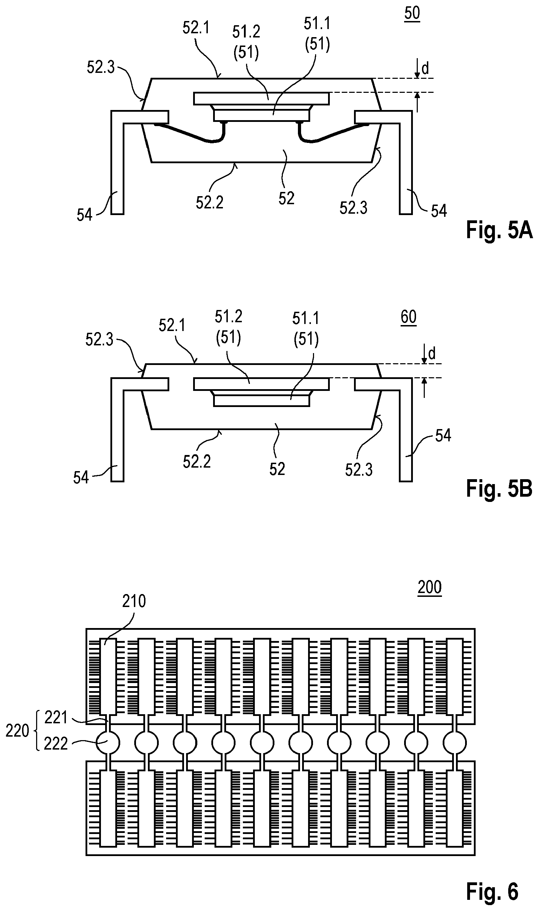

Fig. 5 comprises Fig. 5A and 5B and shows cross-sectional side views of semiconductor packages according to the second aspect.

Fig. 5A shows a semiconductor package 50 comprising a semiconductor module 51 comprising at least one semiconductor die 51.1 disposed on a substrate 51.2 such as a leadframe, an encapsulant 52 embedding the semiconductor module 51, the encapsulant 52 comprising an upper surface 52.1, a lower surface 52.2, and side surfaces 52.3 interconnecting the upper surface 52.1 and the lower surface 52.2, wherein at least part of the side surfaces 52.3 are sawn surfaces.

The semiconductor package 50 may further comprise external leads 54 which in this embodiment are bent at a right angle so that the semiconductor package is designed as a through-hole device.

Sawing the semiconductor packages on the side surfaces results in a surface roughness of the side surfaces 52.3. For example, the so-called square roughness R_{q} of the side surfaces can be greater than 0.5 µm, 1 µm, 2 µm, 5 µm, 10 µm, 20 µm, 50 µm, 100 µm, 200 µm, or 500 µm, depending on the selected sawing process.

In any case, the side surfaces 52.3 of the encapsulant 52 have a greater roughness than the upper and lower surfaces 52.1 and 52.2 of the encapsulant 52 due to the sawing process.

The semiconductor package 50 can be fabricated by the method according to the first aspect so that a distance d between the upper surface of the substrate 51.2 and the upper surface 52.1 of the encapsulant 52 can be in a range between 100 µm and 300 µm for optimal heat dissipation to e.g. a heat sink (not shown) mounted on top of the upper surface 52.1 of the encapsulant 52. In a departure from the method described above according to the first aspect, the distance between the bottom surface of the semiconductor die 51.1 and the bottom surface 52.2 of the encapsulant is greater than the distance d.

Fig. 5B shows a semiconductor package 60 similar to the semiconductor package 50 of Fig. 5A so that the same reference signs were chosen. The only difference to the semiconductor package 50 of Fig. 5A is that the substrate 51.2 is coplanar with upper horizontal portions of the leads 54.

Fig. 6 shows a top view on a mold apparatus for parallel fabrication of a plurality of semiconductor packages.

It is possible to produce a large number of usually identical packages simultaneously if the mold has more than one mold cavity. The molding apparatus 200 as shown in Fig. 6 comprises a plurality of mold cavities 210 each one connected with a feeding system 220 comprising a feeding line 221 and a cull 222 such as those shown and described with reference signs 20, 21 and 22 in connection with Fig. 2A. In the present embodiment each one of the culls 222 is connected by two feeding lines 221 with two mold cavities 210. The molding material is then introduced into the individual cavities 210 simultaneously from a supply container (not shown) through a branched feed line. The culls 222 are connected with the mold cavities by a single fee line 221.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method (100) for fabricating a semiconductor package, comprising:
- providing a mold comprising a mold cavity (110);
- providing a semiconductor device comprising a plurality of semiconductor modules, each one of the semiconductor modules comprising at least one semiconductor die disposed on a substrate (120);
- placing the semiconductor device in the mold cavity (130);
- providing a mold material in a softened state and at least partially filling of the mold cavity with the mold material through a gate (140);
- curing of the mold material (150); and
- sawing the cured intermediate product along saw lines separating the semiconductor modules from each other (160).

2. The method (100) according to claim 1, wherein
the mold comprises an upper horizontal wall, a lower horizontal wall, and vertical side walls interconnecting the upper horizontal wall and the lower horizontal wall, wherein the gate for the passage of the mold material is formed in a vertical side wall.

3. The method according to claim 2, wherein
the semiconductor device is placed in such a way in the mold cavity that an upper surface of the substrate is spaced by a first distance from the upper horizontal wall of the mold, and a lower surface of the substrate is spaced by a second distance from the lower horizontal wall of the mold.

4. The method according to claim 3, wherein
the first distance is greater than the second distance.

5. The method according to claim 3 or 4, wherein
both the first distance and the second distance are less than 1 mm.

6. The method according to any one of the preceding claims, wherein
the plurality of semiconductor modules comprises two or more semiconductor modules arranged laterally side by side along a row.

7. The method according to any one of the preceding claims, wherein
the gate of the mold is connected with a cull, wherein
the cull is connected with at least one more gate of at least one more mold.

8. The method according to claim 7, further comprising a plurality of culls, each one of the culls being connected with at least one gate of at least one mold.

9. The method according to any one of the preceding claims, wherein
the semiconductor package to be fabricated comprises an intelligent power module (IPM) package.

10. A semiconductor package (50; 60), comprising a semiconductor module (51) comprising at least one semiconductor die (51.1) disposed on a substrate (51.2);
an encapsulant (52) embedding the semiconductor module (51), the encapsulant (52) comprising an upper surface (52.1), a lower surface (52.2), and side surfaces (52.3) interconnecting the upper surface (52.1) and the lower surface (52.2), wherein
at least part of the side surfaces (52.3) are sawn surfaces.

11. The semiconductor package according to claim 10, wherein the side surfaces (52.3) of the encapsulant (52) have a greater surface roughness than the upper (52.1) and/or the lower surface (52.2) of the encapsulant (52).

12. The semiconductor package according to claim 10 or 11, wherein
an upper surface of the substrate is spaced by a first distance from the upper horizontal surface of the encapsulant, and a lower surface of the substrate is spaced by a second distance from the lower horizontal surface of the encapsulant.

13. The semiconductor package according to claim 12, wherein the first distance is greater than the second distance.

14. The semiconductor package according to any one of claims 10 to 13, wherein
both the first distance and the second distance are less than 1 mm.

15. The semiconductor package according to any one of the claims 10 to 14, wherein
the semiconductor package comprises an intelligent power module (IPM) package.
